# EUROPÄISCHE PATENTSCHRIFT

(11) **EP 0 512 268 B1**
(45) Veröffentlichungstag und Bekanntmachung des Hinweises auf die Patenterteilung: **09.02.2000**
(21) Anmeldenummer: 92105970.5
(22) Anmeldetag: 07.04.1992
(51) Int. Cl.: G03F 3/10, B41F 7/00, B41J 17/22

(54) **Farbfolien-Bereitstellungsvorrichtung**
Supply apparatus for colour-bearing films
Appareils de disposition pour des films portant de la couleur

(30) Priorität: 02.05.1991 DE 4114314
(43) Veröffentlichungstag der Anmeldung: 11.11.1992
(73) Patentinhaber: E.I. DU PONT DE NEMOURS AND COMPANY, Wilmington Delaware 19898 (US)
(72) Erfinder: Ulrich, Peter, W-6054 Rodgau 6 (DE); Sandner, Helmut, W-6054 Rodgau 3 (DE); François, Robert N., W-6393 Wehrheim (DE); Hawkins, Michael, Halifax HX1 3XQ (GB)
(74) Vertreter: R.A. KUHNEN & P.A. WACKER

(56) Entgegenhaltungen:
- EP-A- 0 255 032
- DE-A- 3 421 925
- DE-A- 3 535 767
- US-A- 4 019 434

## Beschreibung

Die Erfindung betrifft eine Farbfolien-Bereitstellungsvorrichtung mit einer Vorratsrolle zur Aufnahme einer ungebrauchten Farbfolie.

Zur Prüfung von Farbauszügen im Druckereibereich wird eine Bildträgerfolie beispielsweise durch Belichtung an den Stellen, die später Farbe aufnehmen sollen, mit einer klebrigen Oberfläche versehen. Die Bildträgerfolie wird dann zusammen mit einer Farbträgerfolie oder kurz Farbfolie durch einen Laminator geleitet. Der Laminator weist einen aus zwei Walzen gebildeten Walzenspalt auf. In diesem Walzenspalt wird die Farbfolie mit Druck auf die Bildträgerfolie gepreßt. Hinter dem Walzenspalt wird die Farbfolie von der Bildträgerfolie abgezogen. Hierbei bleibt Farbe auf den zuvor klebrig gemachten Bereichen hängen. Der Vorgang wird mit der entsprechenden Anzahl von Farben, in der Regel vier, wiederholt. Danach läßt sich visuell überprüfen, ob der Farbauszug in Ordnung ist, insbesondere, ob die Rasterung stimmt.

Bei bisher bekannten Laminatoren besteht die Farbfolien-Bereitstellungsvorrichtung darin, daß vor dem Walzenspalt eine Reihe von Vorratsrollen für Farbfolien aufgehängt sind. Die Enden der Farbfolien hängen nach unten oder sind, beispielsweise mit einem Klebestreifen, an den jeweiligen Vorratsrollen befestigt. Zum Herstellen eines Farbauszuges ergreift eine Bedienungsperson das Ende der Farbfolie mit der gewünschten Farbe, zieht ein Stück von der Vorratsrolle ab und fädelt das Ende in den Walzenspalt ein, beispielsweise mit Hilfe eines Luftstromes. Die Bildträgerfolie wird dann ebenfalls in den Walzenspalt eingefädelt. Der Walzenspalt wird geschlossen, und die Laminierung kann beginnen. Sobald die Bildträgerfolie durch den Walzenspalt hindurchgelaufen ist, wird der Walzenspalt wieder geöffnet. Die ge- oder verbrauchte Farbfolie wird, beispielsweise mit einem Messer, von der Vorratsrolle abgetrennt. Die Vorratsrolle wird entgegen ihrer Abwicklungsrichtung gedreht, um einen Verbleibenden Farbfolien-Überschuß wieder aufzuwickeln. Die an Teilbereichen der Bildträgerfolie haftende Farbfolie wird dann von der Bildträgerfolie abgezogen. Die nunmehr gebrauchte Farbfolie ist dann Abfall.

Die Handhabung der Farbfolien ist hierbei relativ umständlich. Durch das wiederholte Hin- und Herwickeln der Farbfolien auf den Vorratsrollen kann ein kleiner Farbabrieb der Farbfolie auftreten, der zu einer Verfälschung der Farbauszüge führt. Schließlich ist die Handhabung der gebrauchten Folie umständlich. Die gebrauchten Farbfolien-Abschnitte nehmen im Abfall nicht nur relativ viel Raum ein. Sie lassen sich auch nur mit Schwierigkeiten einer Wiederverwendung zuführen. Weiterhin erfordert es einigen Aufwand und Geschicklichkeit, die Farbfolie von der Bildträgerfolie zu trennen.

Der DE-A- 35 35 767 ist eine Farbtuch-Bereitstellungsvorrichtung für einen Thermodrucker zu entnehmen, die die Merkmale des Oberbegriffs von Anspruch 1 aufweist. Da beim Thermodrucken die Haftung zwischen Farbträger und Bildträger, wenn überhaupt, nur gering ist, ist diesem Dokument auch keine Einrichtung zu entnehmen, die auch bei stärkerer Haftung zwischen Bildträger und Farbträger nach dem Durchtritt durch den Spalt zwischen Thermokopf und Gegendruckwalze eine zuverlässige und schnelle Trennung der beiden Träger gewährleisten würde bzw. zu diesem Zweck vorgesehen ist.

Der Erfindung liegt die Aufgabe zugrunde, die Handhabung der obigen Farbfolie zu erleichtern.

Diese Aufgabe wird bei einer Farbfolien-Bereitstellungsvorrichtung der eingangs genannten Art dadurch gelöst, daß die Vorratsrolle gemeinsam mit einer Abfallrolle zur Aufnahme der gebrauchten Farbfolie in einem kassettenartigen, transportablen Gehäuse gelagert ist, wobei sich ein Abschnitt der Farbfolie zwischen Vorratsrolle und Abfallrolle erstreckt und das Gehäuse eine Öffnung zwischen der Vorratsrolle und der Abfallrolle aufweist, die mindestens so breit wie die Farbfolie ist und einen ungehinderten Zugang zu beiden Seiten der Farbfolie gestattet, wobei diese Vorrichtung dadurch gekennzeichnet ist, daß sich in dem der Abfallrolle zugeordneten Teil des Gehäuses eine Schälkante befindet, die auf die Farbfolie wirkt und in der Bewegungsbann der Farbfolie einen Knick erzeugt.

Die Vorratsrollen für die Farbfolien hängen nun nicht mehr frei an der Eingangsseite des Laminators. Die Vorratsrollen befinden sich vielmehr in jeweils einer Kassette. Diese Kassette dient nicht nur dazu, frische oder ungebrauchte Farbfolie zu spenden. Sie dient gleichermaßen dazu, die gebrauchte Farbfolie auf der Abfallrolle aufzuwickeln. Die gebrauchte Farbfolie wird somit kompakt auf einer Rolle gehalten. Die Abfallrolle kann dann sehr leicht einer Wiederverwertung zugeführt werden. Die Öffnung in der Kassette, die mindestens so breit wie die Farbfolien ist, erlaubt, daß der Laminator trotz Kassette praktisch genauso arbeiten kann wie mit lose aufgehängten Vorratsrollen. Die beiden den Walzenspalt bildenden Walzen können von oben und von unten an die Farbfolie bzw. die Hilfsträgerfolie herangeführt werden, da sie durch die Öffnung einen ungehinderten Zugang zu beiden Seiten der Farbfolien haben. Dadurch, daß die Farbfolie unmittelbar hinter dem Walzenspalt wieder aufgewickelt wird, ergibt sich auch ein automatisches Trennen der Farbfolie von der Bildträgerfolien. Die Bedienungsperson wird damit von diesem Arbeitsgang entlastet. Bei der Kassette wird auch nur so viel Farbfolie von der Vorratsrolle abgewickelt, wie für den aktuellen Laminierungsvorgang notwendig ist. Ein Rückspulen der ungebrauchten Farbfolie erübrigt sich also. Damit kann die Farbfolie in einem höheren Maße unbeschädigt gehalten werden als bisher. Der Vorlauf der Farbfolie also der zum Einfädeln in den Walzenspalt benötigte Abschnitt der Farbfolie, kann kleiner gehalten werden oder entfällt völlig. Mit der gleichen Menge an Farbfolie können also wesentlich mehr Farbauszüge hergestellt werden als bisher. Die Ergiebigkeit der Vorratsrolle steigt. Dadurch, daß die Vorratsrolle und die Abfallrolle permanent mit einem Abschnitt der Farbfolie verbunden sind, entfällt jeglicher Aufwand für die Handhabung eines Endes der Farbfolie. Es muß lediglich die Kassette in den Laminator eingeschoben werden. Danach kann unmittelbar die Laminierung beginnen. Dadurch, daß kein Messer oder ähnliches zum Abtrennen der gebrauchten Farbfolie von der Vorratsrolle notwendig ist, vermindert sich die Verletzungsgefahr für eine Bedienungsperson. Als weiterer vorteilhafter Effekt ergibt sich, daß die Bedienungsperson mit der Farbfolie praktisch nicht mehr in Berührung kommen muß. Hände oder Arbeitsbekleidung werden daher in einem geringeren Maße als bisher verunreinigt. Die Schälkante dient dazu, die Farbfolie von der Bildträgerfolie abzuziehen. Durch den scharfen Knick wird auf die Farbfolie eine Kraft ausgeübt, die in einem relativ steilen Winkel zur Ebene durch den Walzenspalt wirkt. Durch die Schälkante wird ein zuverlässiges Abheben der Farbfolie von der Bildträgerfolie erreicht, und zwar auch in den klebrigen Bereichen.

Bevorzugterweise weist der Knick einen Winkel von ≧ 70° auf. Es wird also ein sehr scharfes Umlenken der Farbfolie erreicht. Die Farbfolie wird unmittelbar hinter der Schälkante annähernd senkrecht von der Bildträgerfolie abgezogen. Bevorzugt ist diese Schälkante einstellbar durchbiegbar anzubringen.

Vorteilhafterweise ist der Schälkante eine Umlenkeinrichtung zugeordnet. Die Farbfolie verläuft dann zwischen der Schälkante und der Umlenkeinrichtung. Durch die Umlenkeinrichtung kann die Bewegungsbahn der Farbfolie noch genauer gesteuert und der Knick noch präziser definiert werden.

Hierbei ist bevorzugt, daß die Umlenkeinrichtung durch ein Leitblech gebildet ist. Das Leitblech verteilt die auf die Farbfolie wirkende Kraft gleichmäßiger und ist insbesondere für dünnere Papiere geeignet.

Mit Vorteil ist eine Farbfolien-Leiteinrichtung vorgesehen, die zwischen mindestens zwei Stellungen verlagerbar ist und die Bahn der Farbfolie zumindest im Bereich der Öffnung verändert. Die Farbfolien-Leiteinrichtung dient insbesondere dazu, der Farbfolie einen anderen Verlauf zu geben, wenn die Kassette in den Laminator eingeschoben werden soll. Wenn der Walzenspalt geöffnet ist, steht zwar ein gewisser Platz zur Verfügung, in den die Farbfolie eingeschoben werden kann. Da jedoch die Farbfolie einerseits unter Spannung stehen soll, andererseits die entsprechende Laminatorwalze im Ruhezustand auf die Farbfolie wirken soll, würde die Farbfolie unter Umständen an dieser Walze hängenbleiben, wenn die Kassette in den Laminator eingeschoben wird. Durch die Farbfolien-Leiteinrichtung kann nun die Bahn der Farbfolie so geändert werden, daß die Farbfolie an der betreffenden Walze vorbeigefuhrt werden kann. Nach dem Einführen der Kassette in den Laminator kann die Farbfolien-Leiteinrichtung wieder in eine andere Position gebracht werden, so daß die Farbfolie ihre Arbeitsstellung einnimmt.

Hierbei ist es von Vorteil, wenn die Farbfolien-Leiteinrichtung eine sich quer zur Bewegungsrichtung der Farbfolie erstreckende Stange aufweist, die auf beiden Seiten in je einem Rad gelagert ist, das jeweils drehbar im Gehäuse gelagert ist, wobei die Achsen der beiden Räder auf einer geraden Linie liegen und eine Betätigungseinrichtung vorgesehen ist, die beide Räder synchron dreht. Die Stange läßt sich mit Hilfe der Räder zwischen den beiden Positionen verlagern. Hierbei ist es von Vorteil, wenn die Stange in der Arbeitsposition nicht mit der Farbfolie in Berühung steht. Sollte dies doch der Fall sein, ist dies auch nicht von Nachteil, da die Farbfolie problemlos an der Stange gleiten kann. Da die Betätigungseinrichtung beide Räder synchron dreht, ist gewährleistet, daß sich die Stange immer in einer Richtung senkrecht zur Bewegungsrichtung der Farbfolie erstreckt. Ein Verkanten oder Verziehen der Farbfolie ist dabei ausgeschlossen.

Vorteilhafterweise weist die Betätigungseinrichtung eine durchgehende, im Gehäuse gelagerte Betätigungsachse auf, auf der zwei Zahnräder drehfest angeordnet sind, die mit einer Außenverzahnung auf den Rädern kämmen. Über die Betätigungsachse läßt sich das notwendige Drehmoment übertragen, ohne daß es zu einer Verwindung der Farbfolien-Leiteinrichtung kommt.

Hierbei ist bevorzugt, daß auf der Betätigungsachse eine Umlenkrolle drehbar gelagert ist. Da die Farbfolie in der Regel um die Betätigungsachse herumgeführt werden muß, erleichtert die Umlenkrolle den Farbfolientransport.

Auch ist bevorzugt, daß die Betätigungsachse auf beiden Seiten das Gehäuse durchsetzt und und an einem Ende eine Handhabe und am anderen Ende ein Schalthebel drehfest mit der Betätigungsachse verbunden sind. Über die Handhabe läßt sich dann die Betätigungsachse verdrehen. Dies hat zum einen die Wirkung, daß die Farbfolien-Leiteinrichtung aus der einen Stellung, der Einschubstellung, in die andere Stellung, die Arbeitsstellung, verschoben wird. Die Farbfolie liegt dann in der eingeschobenen Stellung der Kassette an der entsprechenden Walze des Walzenspalts an. Zum anderen wird der Schalthebel ebenfalls durch die Handhabe betätigt. Er kann dann in dem Laminator einen Schalter betätigen, der anzeigt, daß eine Kassette eingeführt ist, gegebenenfalls auch welche Farbe. Gleichzeitig kann der Schalthebel auch eine mechanische Verriegelung auslösen oder bewirken, die verhindert, daß die Kassette wieder aus dem Laminator entfernt werden kann. Dies ist erst möglich, wenn die Handhabe wieder in eine andere Position gedreht wird, in der die Farbfolien-Leiteinrichtung in der Einschubstellung ist und die Verriegelung gelöst ist.

In einer bevorzugten Ausführungsform ist für die Vorratsrolle und die Abfallrolle jeweils eine Rollenbremseinrichtung vorgesehen, die die jeweilige Rolle bremst, wenn von außen keine Kräfte auf sie wirken. Solange die Kassette außerhalb des Laminators ist, wirken keine Kräfte auf die jeweiligen Rollenbremseinrichtungen. Die Rollenbremseinrichtungen bremsen dann die Vorratsrolle und die Abfallrolle. Die Farbfolie bleibt in ihrem vorher eingenommenen Zustand, da weder die Vorratsrolle noch die Abfallrolle auf- oder abgewickelt werden können. Insbesondere bleibt die Spannung der Farbfolie erhalten. Die Farbfolie kann dann unmittelbar nach dem Einsetzen der Kassette in den Laminator weiterverarbeitet werden.

Hierbei ist bevorzugt, daß die Rollenbremseinrichtung als Reibungskupplung ausgebildet ist, deren eine Reibfläche mit dem Gehäuse und deren andere Reibfläche mit der Rolle verbunden ist. Eine Reibungskupplung kann die Rolle in jeder Winkelposition bremsen. Die Rolle wird hierbei jedoch nicht verriegelt, d.h. es ist notfalls eine Drehbewegung möglich, wenn ein Drehmoment auf die Rolle wirkt, welches größer als das Bremsmoment ist. Das Bremsmoment kann so eingestellt werden, daß ein Reißen der Farbfolie verhindert wird, wenn eine bestimmte Kraft auf die Farbfolie wirkt. Mit Vorteil ist ein vorgespanntes Betätigungsglied für die Rollenbremseinrichtung vorgesehen, das in der Ruheposition die Reibflächen aneinander zur Anlage bringt. Die Rollenbremseinrichtung wird also nur dann gelöst, wenn das Betätigungsglied betätigt wird. Da das Betätigungsglied vorgespannt ist, nimmt es seine Ruheposition immer dann ein, wenn keine äußeren Kräfte auf die Kassette oder das Betätigungsglied wirken. Dies ist immer dann der Fall, wenn die Kassette aus dem Laminator ausgebaut ist. Durch die Vorspannung ergibt sich der vorteilhafte Effekt, daß beim Ausbau der Kassette aus dem Laminator, d.h. beim Vermindern der Kräfte auf das Betätigungsglied, die Rollenbremseinrichtung einrückt, also die Vorratsrolle bzw. die Abfallrolle bremst.

In einer vorteilhaften Ausgestaltung weist das Gehäuse zwei miteinander verbundene Seitenwände auf, in denen die Vorratsrolle und die Abfallrolle drehbar gelagert sind und von denen mindestens eine eine vom Rand zwischen Vorratsrolle und Abfallrolle ausgehende Ausnehmung aufweist. Diese Ausführungsform kann seitlich, d.h. in Richtung der Achsen der den Walzenspalt bildenden Walzen in den Laminator eingeschoben werden. Die Aussparung ist hierbei dafür vorgesehen, daß die Kassette an einer der beiden Walzen vorbeigeführt werden kann. Die andere der beiden Walzen befindet sich dann unter- oder oberhalb der Kassette. Man erreicht hierdurch, daß der Stellweg für die den Walzenspalt bildenden Walzen relativ gering gehalten werden kann. Der Walzenspalt muß nicht so groß sein, daß die Kassette mit ihrer gesamten Höhe hindurchgeführt werden kann.

Hierbei ist bevorzugt, daß die Seitenwände eine größere Höhe als der größte Rollendurchmesser aufweisen und die Höhe der Ausnehmung mindestens dem größten Rollendurchmesser entspricht. Damit ist sichergestellt, daß diejenige Walze des Walzenspaltes, für die die Ausnehmung vorgesehen ist, in bezug auf die Kassette weit genug abgesenkt werden kann, daß sie auf den zwischen Vorratsrolle und Abfallrolle befindlichen Abschnitt der Farbfolie abgesenkt werden kann. Statt die Rolle abzusenken, kann auch die Farbfolie angehoben werden.

Zur Lagerung der Abfallrolle und der Vorratsrolle ist bevorzugterweise vorgesehen, daß die Seitenwände für die Vorratsrolle und für die Abfallrolle jeweils einen vom Rand ausgehenden Lagerschlitz aufweisen, in dem jeweils ein Rollenlagerzapfen gelagert ist. Die Vorratsrolle und die Abfallrolle können also von einem Rand her in die Kassette eingesetzt werden. Die Lagerzapfen können dabei in den Schlitz eingeführt werden. Die Lagerzapfen sind damit zumindest von drei Seiten umschlossen, so daß hierdurch bereits eine relativ gute Lagerung von Vorratsrolle und Abfallrolle gewährleistet ist.

Bevorzugterweise weisen die Vorratsrolle und/oder die Abfallrolle einen zumindest an den Enden hohlen Kern auf, in den die Lagerzapfen eingeführt sind. Vorratsrolle und/oder Abfallrolle können also so ausgebildet sein, daß sie genauso breit sind wie die Farbfolie. Die Lagerung erfolgt dann über von außen einsteckbare Lagerzapfen. Dies erleichtert den Transport und die Vorratshaltung von Vorratsrollen und/oder Abfallrollen, da sie dicht an dicht gestapelt werden können. Hierbei ist es bevorzugt, daß die Lagerzapfen an ihrem in den Kern einführbaren Ende radial gerichtete und sich axial erstreckende Schneiden aufweisen. Über die Schneiden wird zumindest eine kraftschlüssige, in den meisten Fällen aber eine formschlüssige Verbindung zwischen Lagerzapfen und Kern erreicht. Hierdurch wird zum einen sichergestellt, daß die Rollen mit den Lagerzapfen drehfest verbunden sind. Und zum andern ist die Verbindung lösbar. In einer weiteren Alternative kann vorgesehen sein, daß der Kern an seiner Innenwand eine Vielzahl von Drehmomentangriffsflächen aufweist, wobei die Lagerzapfen die entsprechende Negativform der Drehmomentangriffsflächen aufweisen. Beispielsweise kann der Kern eine im Querschnitt sechs- oder achteckförmige Ausnehmung aufweisen. Die Lagerzapfen haben dann die entsprechende Form eines Sechs- oder Achtecks. Auch auf diese Weise ist die Übertragung eines Moments von den Lagerzapfen auf die Rolle möglich, wobei die Verbindung zwischen Lagerzapfen und Rolle lösbar ist.

Dies ist insbesondere dann von Vorteil, wenn zumindest die Abfallrolle antreibbar ist. Es müssen dann lediglich die Lagerzapfen angetrieben werden. Über die Schneiden oder die Drehmomentangriffsflächen, die in den Kern eingeführt werden, läßt sich dann ein Antriebsmoment auf die Abfallrolle übertragen. Wenn die Abfallrolle angetrieben ist, läßt sich nach dem Laminieren die verbrauchte Farbfolie problemlos aufwickeln. Zum Antrieb kann der Lagerzapfen der Abfallrolle auf der die Ausnehmung aufweisenden Seite des Gehäuses einen auf der Außenseite des Gehäuses angeordneten Konus mit einer Reibfläche aufweisen. Über den Konus mit der Reibfläche läßt sich eine kraftschlüssige Verbindung im Laminator mit einem Antrieb herstellen. Der Konus hat dabei den Vorteil, daß für die Führung der Kassette in den Laminator eine gewisse Toleranz zulässig ist. Solange die Spitze des Konus in die zugehörige Ausnehmung eingeführt werden kann, ist sichergestellt, daß die Reibfläche auf der Außenseite des Konus mit ihrer entsprechenden Gegenfläche zur Anlage kommt, wodurch eine Mitnahme der Abfallrolle gewährleistet ist. Als weiteres Beispiel für den Antrieb kann ein exzentrisch angeordneter spitz zulaufender Stift auf den Lagerzapfen angeordnet sein, der beim Einführen der Kassette in den Laminator in eines einer Vielzahl von Löchern einer am Antrieb für die Abfallrolle befindlichen Lochscheibe rutscht.

Bevorzugterweise ist für die Vorratsrolle und/oder die Abfallrolle je ein Deckel vorgesehen, der die zugehörige Rolle zumindest teilweise umgreift. Dieser Deckel bietet einen Schutz für die Rollen. Er kann nach dem Einsetzen der Rollen geschlossen werden. Der Deckel kann hierbei eine Seitenwand aufweisen, die bei geschlossenem Deckel auf den Lagerzapfen wirkt. Der Lagerzapfen ist nun auch in die Richtung gesichert, in die sich der Längsschlitz in der Gehäuseseitenwand erstreckt. Bei geschlossenem Deckel kann die Rolle, d.h. die Vorratsrolle oder die Abfallrolle, nicht aus dem Gehäuse herausfallen.

Bevorzugterweise ist der Deckel am Gehäuse angelenkt und klappbar. Damit ist der Deckel unverlierbar mit dem Gehäuse verbunden. Er wird zum Beschicken des Gehäuses mit der Vorratsrolle und der Abfallrolle jeweils einfach abgeklappt. Nach dem Einlegen der Rollen kann der Deckel zugeklappt und damit geschlossen werden.

Vorteilhafterweise ist die Schälkante in den der Abfallrolle zugeordneten Deckel eingearbeitet. Mit dem Schließen des Deckels wird die Schälkante automatisch in die richtige Position gebracht. Sobald der Deckel geschlossen ist, kann die Kassette wie vorgesehen arbeiten.

Vorteilhafterweise ist ein Sensor vorgesehen, der den Durchmesser der Vorratsrolle ermittelt. Mit dem Sensor läßt sich dann eine Überwachung des Vorrats an Farbfolie auf der Vorratsrolle automatisch durchführen. Eine Bedienungsperson wird rechtzeitig gewarnt, wenn der Vorrat an Farbfolie auf der Vorratsrolle zur Neige geht.

In einer bevorzugten Ausführungsform ist eine verschiebbare Abdeckung vorgesehen, die die Farbfolie im Bereich der Öffnung schützt und beim Einlegen der Farbfolien-Bereitstellungsvorrichtung in den Laminator unter Freigabe der Öffnung in das Gehäuse verschoben wird. Insbesondere bei lichtempfindlichen Farbfolien wird dadurch die Handhabung sehr stark vereinfacht. Die Kassetten können nun bei normaler Beleuchtung, also bei Tageslicht oder bei Kunstlicht, gehandhabt werden, ohne daß darauf geachtet werden muß, daß die Farbfolien lichtgeschützt bleiben.

Die Erfindung wird im folgenden anhand eines bevorzugten Ausführungsbeispiels in Verbindung mit der Zeichnung beschrieben. Darin zeigen:
- Fig. 1: eine perspektivische Ansicht einer Kassette, teilweise in Explosionsdarstellung,
- Fig. 2: einen Querschnitt durch die Kassette,
- Fig. 3: einen Schnitt III-III nach Fig. 2,
- Fig. 4: eine vergrößerte Ansicht eines Ausschnitts aus Fig. 3,
- Fig. 5: die Ansicht nach Fig. 4 in einer anderen Betriebsstellung,
- Fig. 6: einen Querschnitt durch eine andere Ausführungsform der Kassette und
- Fig. 7: eine andere Ausführungsform einer Rollenlagerung in Explosionsdarstellung.

Eine Farbfolien-Bereitstellungsvorrichtung ist als Kassette 1 mit einem Gehäuse 2 ausgebildet, das einen Boden 3 und zwei Seitenwände 4, 5 aufweist. In jeder Seitenwand 4, 5 sind jeweils zwei vom oberen Rand der Seitenwand ausgehende Längsschlitze 6, 7, 8, 9 vorgesehen. Die Längsschlitze 6, 7 bilden hierbei ein Lager für eine Abfallrolle 10. Die Längsschlitze 8, 9 bilden ein Lager für eine Vorratsrolle 11.

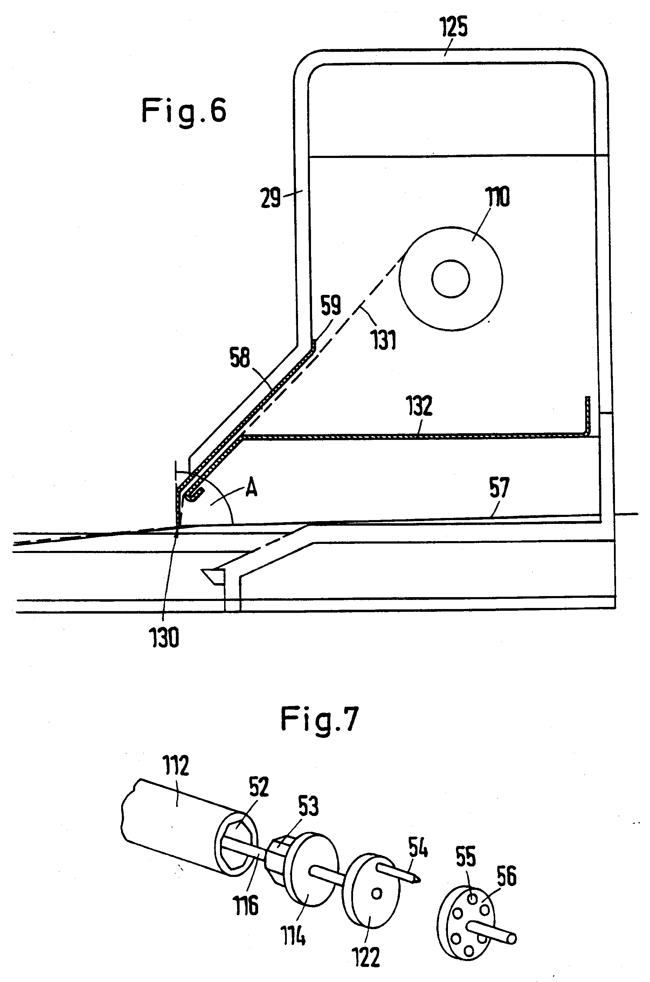

Vorratsrolle 11 und Abfallrolle 10 weisen einen zumindest an den Enden hohlen Kern 12 auf. In den Kern 12 werden von beiden Seiten Lagerzapfen 13, 14 eingeführt. Jeder Lagerzapfen weist dabei eine Reihe von radial gerichteten und sich axial erstreckenden Schneiden 15 auf. Diese Schneiden 15 dringen teilweise in den Kern der betreffenden Rolle ein, stellen also eine kraftschlüssige bzw. sogar formschlüssige Verbindung zwischen den Lagerzapfen 13, 14 und dem Kern 12 her. Eine Alternative zur Verbindung zwischen Lagerzapfen und Kern zeigt Fig. 7, in der entsprechende Teile mit um 100 erhöhten Bezugszeichen versehen sind. Der Kern 112 ist ebenfalls hohl. Die den Kern durchsetzende Ausnehmung 52 ist im Querschnitt achteckig. Der Lagerzapfen hat anstelle der Schneiden einen Fortsatz 53, der im Querschnitt ebenfalls achteckig ist. Der Fortsatz 53 ist so ausgebildet, daß er in die Öffnung 52 des Kernes 112 hineinpaßt. Über die acht Flächen des Fortsatzes 53 läßt sich ein Drehmoment übertragen. Die beiden Lagerzapfen 13, 14 sind dabei über eine Achswelle 16 miteinander verbunden. Die Achswelle 16 ist mindestens mit einem Lagerzapfen 13, 14 drehfest verbunden. Außerdem sind außerhalb der Lagerzapfen 13, 14 auf der Achswelle noch Lagerbuchsen 17, 18 angeordnet, die in bezug zu den Seitenwanden 4, 5 des Gehäuses 2 drehfest sind und in denen sich die Achswelle 16 frei drehen kann.

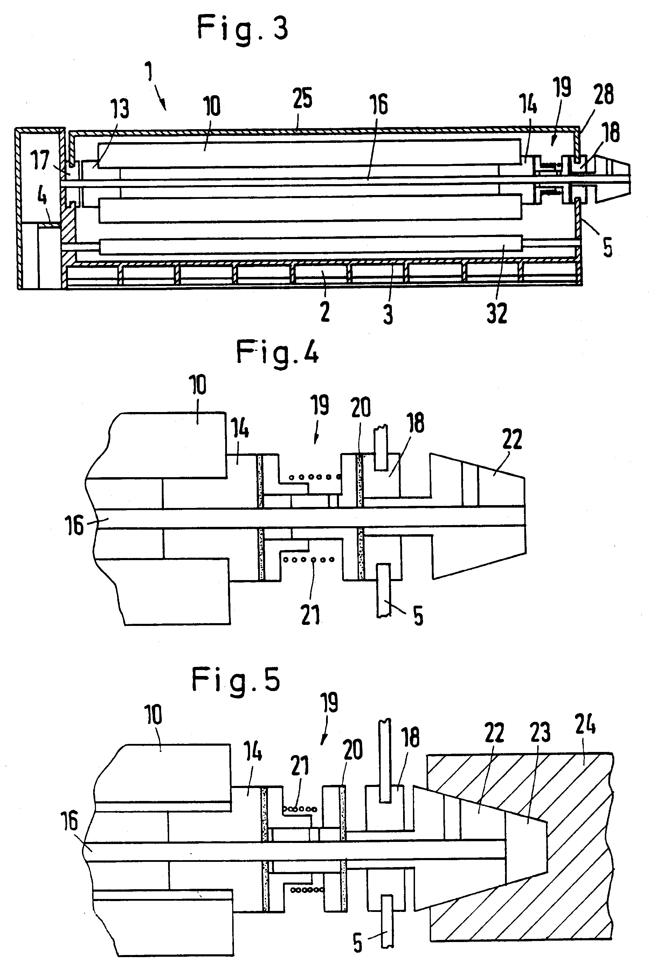

Auf der Achswelle 16 ist ferner eine Bremseinrichtung 19 angeordnet, die im Zusammenhang mit den Fig. 4 und 5 näher erläutert wird. Die Rollenbremseinrichtung 19 ist als Reibungskupplung ausgebildet, d.h. sie weist eine Reibfläche 20 auf, die durch die Kraft einer Feder 21 gegen die Seitenwand 5 des Gehäuses bzw. gegen die im Gehäuse drehfest angeordnete Lagerbuchse 18 gepreßt wird. Solange die Feder entspannt ist, d.h. solange keine äußeren Kräfte auf die Achswelle 16 wirken, wird die Abfallrolle 10 durch den Reibschluß zwischen der Reibfläche 20 und der Lagerbuchse 18 gebremst. Es handelt sich hier lediglich um einen Reibschluß. Dies hat den Vorteil, daß die Abfallrolle in jeder Winkelposition gebremst werden kann. Außerdem kann die Abfallrolle 10 auch gegen die Reibkraft gedreht werden, wenn ein Moment auf die Abfallrolle 10 aufgebracht wird, das das Bremsmoment überwindet. Das Bremsmoment wird nur so groß gewählt, daß das mit Hilfe der Farbfolie übertragbare Moment geringere Kräfte erfordert, als zum Durchreißen der Farbfolie erforderlich wären. Wenn also durch eine ungeschickte Handhabung die Farbfolie irgendwo hängen bleiben sollte, wird verhindert, daß die Farbfolie reißt. Sie wird vielmehr von der Abfallrolle abgewickelt. Die Rollenbremseinrichtung 19 wird gelöst, wenn die Kassette in einen Laminator eingesetzt wird. In diesem Fall wird ein als Konus ausgebildetes Betätigungsglied 22 gegen die Kraft der Feder nach innen, d.h. auf das Gehäuse 2 zu, verschoben. Die Reibungsfläche 20 wird dadurch von dem Gehäuse 5 bzw. der Lagerbuchse 18 gelöst. Die Reibungskraft wird dabei aufgehoben. Vorteilhafterweise wird hierbei das Betätigungsglied 22 in eine entsprechende konische Ausnehmung 23 eines Antriebs 24 des Laminators geführt. Durch die Konusform ergibt sich eine gewisse Selbstzentrierung, so daß die Führung der Kassette 1 im Laminator mit einem gewissen Spiel behaftet sein kann. Wenn der Antrieb 24 gedreht wird, wird die Abfallrolle über das Betätigungsglied 22, das mit der Achswelle 16 drehfest verbunden ist, gleichfalls mitgedreht. Hierdurch kann beim Laminieren eine automatische Aufwicklung der Farbfolie auf die Abfallrolle bewirkt werden. In Fig. 7 ist eine Alternative für den Antrieb dargestellt. Anstelle des Konus 22 ist eine Scheibe 122 mit einem spitz zulaufenden Stift 54 vorgesehen, der auf der Scheibe 122 exzentrisch gelagert ist. Der Stift 54 wird, wenn die Kassette in den Laminator eingeführt wird, in ein Loch 55 einer Antriebsscheibe 56 eingeführt. Wenn sich die Antriebsscheibe 56 dreht, wird über den Stift 54 ein Antriebsmoment auf die Welle 116 übertragen.

Wenn die Kassette 1 aus dem Laminator herausgezogen wird, löst sich das Betätigungsglied 22 aus dem Antrieb 24, und die Kupplungsfläche 20 kommt unter der Kraft der Feder 21 wieder mit der Lagerbuchse 18 in Reibkontakt. Die Abfallrolle 10 bzw. die Vorratsrolle 11 werden dadurch automatisch gebremst.

Die Kassette 1 weist ferner eine Abdeckung 51 auf, die im Gehäuse 2 verschiebbar gelagert ist. Diese Abdeckung 51 deckt die Öffnung 48 ab, was bei lichtempfindlichen Farbfolien notwendig ist. Wenn die Kassette 1 in den Laminator hineingeschoben wird, wird die Abdeckung 51 in das Gehäuse geschoben, so daß sie die Öffnung 48 freigibt.

Für die Abfallrolle 10 ist ein Deckel 25 vorgesehen, der auf das Gehäuse 2 aufsteckbar ist. Nach dem Aufstecken greift er mit einer Nase 26 hinter einen Vorsprung 27 und ist damit am Gehäuse 2 befestigt. Durch ein leichtes Ausbiegen der den Vorsprung 26 tragenden Wand läßt sich der Deckel 25 aber leicht wieder vom Gehäuse 2 entfernen. Das Gehäuse 2 bietet einen Schutz für die Abfallrolle 10, d.h. ein unbeabsichtigtes Berühren der Abfallrolle 10 durch eine Bedienungsperson wird damit zuverlässig ausgeschlossen. Der Deckel 25 weist auf jeder Seite eine Seitenwand 28 auf, die im geschlossenen Zustand auf der Lagerbuchse 18 aufliegt und die Lagerbuchse 18 im Längsschlitz 7 festlegt. Gleiches gilt natürlich auf für die anderen Längsschlitze 6, 8 und 9, auf die entsprechende Seitenwände entsprechender Deckel wirken. Die Abfallrolle 10 und die Vorratsrolle 11 sind dadurch auch gegen ein Herausrutschen nach oben gesichert.

Der Deckel 25 weist an der der Vorratsrolle 11 benachbarten Querwand 29 eine Schälkante 30 auf, an der in der Bahn einer zwischen Vorratsrolle 11 und Abfallrolle 10 verlaufenden Farbfolie 31 ein scharfer Knick erzeugt wird. Zur besseren Kontrolle dieses Knickes kann im Bereich der Schälkante 30 eine Umlenkeinrichtung in Form einer Umlenkrolle 32 angeordnet sein, die die Farbfolie 31 hinter der Schälkante 30 unmittelbar nach oben leitet. Der Winkel, den die Schälkante 30 verursacht, ist bevorzugterweise größer als 70°.

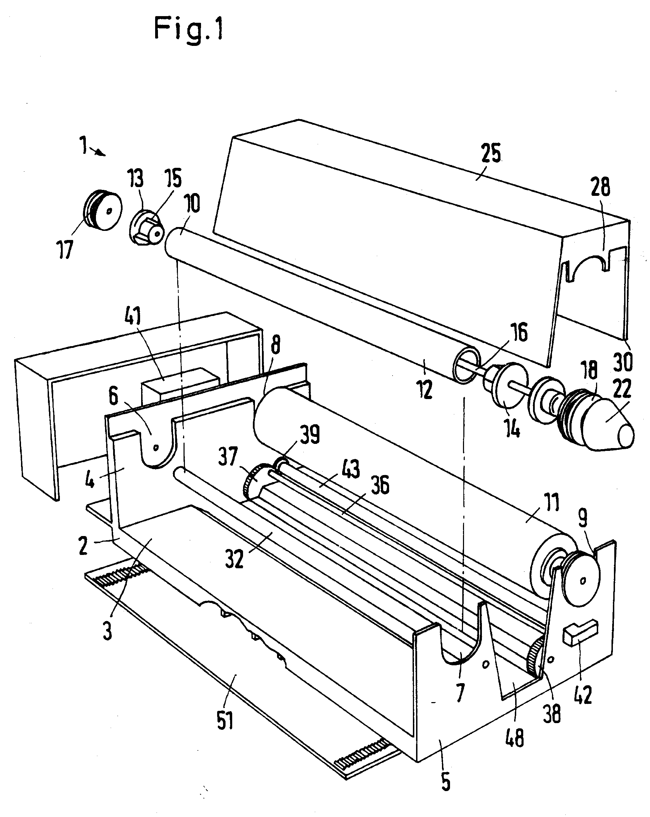

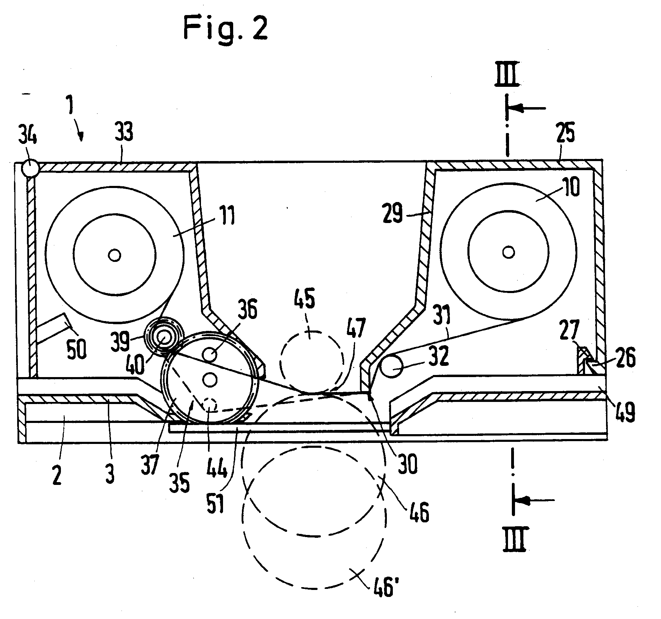

Fig. 6 zeigt eine andere Ausführungsform, bei der die Umlenkeinrichtung durch ein Leitblech 132 gebildet ist. In Fig. 6 sind Elemente, die denen der Fig. 1 und 2 entsprechen, mit um 100 erhöhten Bezugszeichen versehen. Eingezeichnet ist hier auch der Winkel A, den der durch die Schälkante 130 verursachte Winkel bildet. Deutlich ist zu erkennen, wie die Farbfolie 131 von der Bildträgerfolie 57 nahezu senkrecht abgezogen wird. Das Leitblech 132 ist insbesondere bei dünnen Papieren sinnvoll. Die auf die Farbfolie 131 wirkende Kraft wird dann gleichmäßiger verteilt. Die Wickelrichtung der Abfallrolle 110 ist gegenüber der der Fig. 2 umgedreht. Die Schälkante 130 ist deswegen als Teil eines Blechs 58 ausgebildet, das am oberen Ende eine Rundung 59 aufweist. Wenn sich der Durchmesser der Abfallrolle 110 vergrößert, kann die Farbfolie 131 an der Rundung 59 entlanggleiten. Auch hier ist die Schälkante 130 in den der Abfallrolle 110 zugeordneten Deckel eingearbeitet.

Auch für die Vorratsrolle 11 ist ein Deckel 33 vorgesehen. Der Deckel 33 ist am Gehäuse 2 angelenkt, d.h. über ein Scharnier 34 mit dem Gehäuse klappbar verbunden. Der Deckel 33 ist also am Gehäuse 2 unverlierbar befestigt. Der Deckel 33 kann aber auch, genau wie der Deckel 25, aufsteckbar sein. Umgekehrt kann auch der Deckel 25 am Gehäuse angelenkt sein. Der Deckel 33 weist, genau wie der Deckel 25, in nicht dargestellter Weise auf jeder Seite eine Seitenwand auf, die mit den in den Längsschlitzen 8, 9 der Seitenwände 4, 5 des Gehäuses 2 befindlichen Lagerbuchsen zusammenwirkt.

Im Gehäuse 2 ist ferner eine Farbfolien-Leiteinrichtung 35 vorgesehen. Die Farbfolien-Leiteinrichtung 35 weist eine Stange 36 auf, die an ihren beiden Enden in jeweils einem Zahnrad 37, 38 befestigt ist. Die beiden Zahnräder 37, 38 kämmen mit Antriebszahnrädern 39, die drehfest mit einer Betätigungsachse 40 verbunden sind. Die Betätigungsachse 40 weist an einem Ende eine nicht näher dargestellte Handhabe 41 und am anderen Ende einen Schalthebel 42 auf, die mit der Betätigungsachse 40 drehfest verbunden sind. Ferner ist auf der Betätigungsachse 40 eine Umlenkrolle 43 einstellbar durchbiegbar gelagert.

Wenn nun die Handhabe 41 bewegt wird, wird die Betätigungsachse 40 gedreht. Hierbei werden die Zahnräder 37, 38 durch die Antriebszahnräder 39 synchron gedreht. Die Stange 36 verlagert sich aus der durchgezogen dargestellten Position in die gestrichelt dargestellte Position 44. Hierbei drückt sie auf die Farbfolie 31. Die Farbfolie wird dadurch in dem Bereich zwischen den beiden Deckeln 25, 33 um ein vorbestimmtes Maß abgelenkt. Gleichzeitig wird der Schalthebel 42 verdreht.

Die Verwendung der Kassette wird anhand des in Fig. 2 dargestellten Beispiels erläutert. Die Kassette 1 ist dafür vorgesehen, in einem Laminator verwendet zu werden, von dem zwei Walzen, nämlich eine obere Walze 45 und eine untere Walze 46 dargestellt sind, die zusammen einen Walzenspalt 47 bilden. Bevor die Kassette 1 in den Laminator eingeschoben wird, wird die untere Walze 46 abgesenkt in eine Position 46'. Der Walzenspalt 47 wird dadurch vergrößert. Vor dem Einführen der Kassette 1 wird die Farbfolien-Leiteinrichtung 35 betätigt, d.h. die Stange 36 wird in die Position 44 gedreht. Die Farbfolie 31 wird dadurch so weit abgesenkt, daß sie problemlos unter die Walze 45 paßt. Die Kassette 1 kann nun seitlich, d.h. in Richtung der Längsachsen der Walzen 45, 46 in den Laminator eingeschoben werden. Hierbei dringt die obere Walze 45 durch eine in der Seitenwand 5 des Gehäuses 2 vorgesehene Ausnehmung 48 ein. Da die Farbfolie 31 durch die Farbfolien-Leitvorrichtung abgesenkt worden ist, bleibt die Farbfolie 31 nicht an der Walze 45 hängen. Nach dem Einschieben der Kassette 1 wird die Farbfolien-Leiteinrichtung 35 durch die Handhabe 41 betätigt. Hierdurch wird nicht nur die Stange 36 aus der Position 44 entfernt, sondern es wird auch der Schalthebel 42 bewegt, der zum einen im Laminator einen nicht näher dargestellten Schalter betätigen kann und zum anderen auch für eine mechanische Verriegelung sorgt, so daß die Kassette 1 im verriegelten Zustand nicht aus dem Laminator herausgezogen werden kann. Die untere Walze 46 wird dann wieder hochgefahren und der Walzenspalt 47 geschlossen. Die Walzen 45 und 46 befinden sich dann zumindest teilweise innerhalb der Kassette 1, da sie von oben und unten durch eine zwischen der Vorratsrolle und der Abfallrolle 10 befindliche Öffnung in der Kassette 1, die mindestens so breit wie die Farbfolie 31 ist, in die Kassette 1 eindringen und an der Farbfolie zur Anlage gebracht werden können. Eine Bildträgerfolie ist vorher in den Walzenspalt 47 eingelegt worden. Die untere Walze 46 wird dann angetrieben, wodurch die Farbfolie 31 zusammen mit der nicht dargestellten Bildtragerfolie durch den Walzenspalt 47 befördert wird. Kurz hinter dem Verlassen des Walzenspaltes 47 wird die Farbfolie 31 von der Bildträgerfolie unter dem Einfluß der Schälkante 30 abgezogen. Auf die Farbfolie 31 wirkt durch die Schälkante 30 eine Kraft, die im wesentlichen nach oben, also von der etwa in der Ebene des Walzenspaltes 47 befindlichen Bildträgerfolie weg, gerichtet ist. An einem Ausgang 49 des Gehäuses 2 erscheint dann die Bildträgerfolie mit dem gewünschten Farbauftrag an den zuvor klebrig gemachten Bereichen, ohne daß die Farbfolie 31 noch weiter gehandhabt werden muß. Nach dem ersten Farbauftrag wird die Kassette gewechselt, d.h. der Walzenspalt 47 wird geöffnet, die Handhabe 41 wird betätigt, um den Schalthebel 42 aus seiner Verriegelungsposition zu lösen und die Stange 36 in die Position 44 abzusenken, und die Kassette 1 kann aus dem Laminator entfernt werden. Hierauf wird eine andere Kassette mit einer anderen Farbe in den Laminator eingesetzt. Die Oberfläche der Bildträgerfolie wird dann an anderen Bereichen, die die andere Farbe aufnehmen sollen, klebrig gemacht und dann erneut durch den Laminator geschickt.

In der Kassette 1 ist ein Sensor 50 vorgesehen, der den Durchmesser der Vorratsrolle 11 ermittelt. Es kann eine Anzeigevorrichtung vorgesehen sein, die den Durchmesser anzeigt und eine Bedienungsperson rechtzeitig warnt, wenn der Vorrat der Farbfolie 31 auf der Vorratsrolle 11 zur Neige zu gehen droht. Die Bedienungsperson kann dann rechtzeitig eine neue Kassette verwenden oder eine neue Vorratsrolle 11 in die Kassette 1 einsetzen. Die verbrauchte Farbfolie ist dann auf der Abfallrolle 10 aufgewickelt. Sie kann dann vollständig einer Wiederverwertung zugeführt werden.

## Patentansprüche

1. Farbfolien-Bereitstellungsvorrichtung mit einer Vorratsrolle zur Aufnahme einer ungebrauchten Farbfolie, bei der die Vorratsrolle (11) gemeinsam mit einer Abfallrolle (10) zur Aufnahme der gebrauchten Farbfolie (31) in einem kassettenartigen, transportablen Gehäuse (2) gelagert ist, wobei sich ein Abschnitt der Farbfolie (31) zwischen Vorratsrolle (11) und Abfallrolle (10) erstreckt und das Gehäuse (2) eine Öffnung zwischen der Vorratsrolle und der Abfallrolle aufweist, die mindestens so breit wie die Farbfolie ist und einen ungehinderten Zugang zu beiden Seiten der Farbfolie gestattet, dadurch gekennzeichnet, daß sich in dem der Abfallrolle (10) zugeordneten Teil des Gehäuses (2) eine Schälkante (30) befindet, die auf die Farbfolie wirkt und in der Bewegungsbann der Farbfolie einen Knick erzeugt.

2. Vorrichtung nach Anspruch 1, dadurch gekennzeichnet, daß der Knick einen Winkel ≧ 70° aufweist.

3. Vorrichtung nach Anspruch 1 oder 2, dadurch gekennzeichnet, daß der Schälkante (30) eine Umlenkeinrichtung (32, 132) zugeordnet ist.

4. Vorrichtung nach Anspruch 3, dadurch gekennzeichnet, daß die Umlenkeinrichtung durch ein Leitblech (132) gebildet wird.

5. Vorrichtung nach einem der Ansprüche 1 bis 4, dadurch gekennzeichnet, daß eine Farbfolien-Leiteinrichtung (35) vorgesehen ist, die zwischen mindestens zwei Stellungen (36, 44) verlagerbar ist und die Bahn der Farbfolie zumindest im Bereich der Öffnung verändert.

6. Vorrichtung nach Anspruch 5, dadurch gekennzeichnet, daß die Farbfolien-Leiteinrichtung (35) eine sich quer zur Bewegungsrichtung der Farbfolie erstreckende Stange (36) aufweist, die auf beiden Seiten in je einem Rad (37, 38) gelagert ist, das jeweils drehbar im Gehäuse gelagert ist, wobei die Achsen der beiden Räder (37, 38) auf einer geraden Linie liegen und eine Betätigungseinrichtung (40) vorgesehen ist, die beide Räder (37, 38) synchron dreht.

7. Vorrichtung nach Anspruch 6, dadurch gekennzeichnet, daß die Betätigungseinrichtung (40) eine durchgehende, im Gehäuse (2) gelagerte Betätigungsachse aufweist, auf der zwei Zahnräder (39) drehfest angeordnet sind, die mit einer Außenverzahnung auf den Rädern (37, 38) kämmen.

8. Vorrichtung nach Anspruch 7, dadurch gekennzeichnet, daß auf der Betätigungsachse eine Umlenkrolle (43) drehbar gelagert ist.

9. Vorrichtung nach Anspruch 7 oder 8, dadurch gekennzeichnet, daß die Betätigungsachse auf beiden Seiten das Gehäuse durchsetzt und und an einem Ende eine Handhabe (41) und am anderen Ende ein Schalthebel (42) drehfest mit der Betätigungsachse verbunden sind.

10. Vorrichtung nach einem der Ansprüche 1 bis 9, dadurch gekennzeichnet, daß für die Vorratsrolle (11) und die Abfallrolle (10) jeweils eine Rollenbremseinrichtung (19) vorgesehen ist, die die jeweilige Rolle bremst, wenn von außen keine Kräfte auf sie wirken.

11. Vorrichtung nach einem der Ansprüche 1 bis 10, dadurch gekennzeichnet, daß das Gehäuse (2) zwei miteinander verbundene Seitenwände (4, 5) aufweist, in denen die Vorratsrolle (11) und die Abfallrolle (10) drehbar gelagert sind und von denen mindestens eine eine vom Rand zwischen Vorratsrolle und Abfallrolle ausgehende Ausnehmung (48) aufweist.

12. Vorrichtung nach Anspruch 11, dadurch gekennzeichnet, daß die Seitenwände (4, 5) eine größere Höhe als der größte Rollendurchmesser aufweisen und die Höhe der Ausnehmung (48) mindestens dem größten Rollendurchmesser entspricht.

13. Vorrichtung nach Anspruch 11 oder 12, dadurch gekennzeichnet, daß die Seitenwände (4, 5) für die Vorratsrolle (11) und für die Abfallrolle (10) jeweils einen vom Rand ausgehenden Lagerschlitz (6, 7, 8, 9) aufweisen, in dem jeweils ein Rollenlagerzapfen (13, 14) gelagert ist.

14. Vorrichtung nach Anspruch 13, dadurch gekennzeichnet, daß die Vorratsrolle und/oder die Abfallrolle einen zumindest an den Enden hohlen Kern (12) aufweisen, in den die Lagerzapfen (13, 14) eingeführt sind.

15. Vorrichtung nach einem der Ansprüche 1 bis 14, dadurch gekennzeichnet, daß zumindest die Abfallrolle (10) antreibbar ist.

16. Vorrichtung nach einem der Ansprüche 1 bis 15, dagekennzeichnet, daß für die Vorratsrolle (11) und/oder die Abfallrolle (10) je ein Deckel (33, 25) vorgesehen ist, der die zugehörige Rolle zumindest teilweise umgreift.

17. Vorrichtung nach Anpruch 16, dadurch gekennzeichnet, daß der Deckel (33) am Gehäuse (2) angelenkt und klappbar ist.

18. Vorrichtung nach einem der Ansprüche 1 bis 17, dadurch gekennzeichnet, daß die Schälkante (30) in den der Abfallrolle (10) zugeordneten Deckel (25) eingearbeitet ist.

19. Vorrichtung nach einem der Ansprüche 1 bis 18, dadurch gekennzeichnet, daß ein Sensor (50) vorgesehen ist, der den Durchmesser der Vorratsrolle (11) ermittelt.

20. Vorrichtung nach einem der Ansprüche 1 bis 19, dadurch gekennzeichnet, daß eine verschiebbare Abdeckung (35) vorgesehen ist, die die Farbfolie (31) im Bereich der Öffnung (48) schützt und beim Einlegen der Farbfolien-Bereitstellungsvorrichtung in einem Laminator unter Freigabe der Öffnung (48) in das Gehäuse (2) verschoben wird.

## Claims

1. Apparatus for providing colour films, having a supply roller for holding an unused colour film, wherein the supply roller (11) is mounted together with a waste roller (10) for receiving the used colour film (31) in a cassette-like, transportable housing (2), a section of the colour film (31) extending between the supply roller (11) and the waste roller (10), and the housing (2) having an opening between the supply roller and the waste roller which is at least as wide as the colour film and provides unrestricted access to both sides of the colour film, characterised in that, in the part of the housing (2) associated with the waste roller (10), there is a peeling edge (30) which acts on the colour film and produces a bend in the path of travel of the colour film.

2. Apparatus according to claim 1, characterised in that the bend has an angle ≥ 70°.

3. Apparatus according to claim 1 or 2, characterised in that guide means (32, 132) are associated with the peeling edge (30).

4. Apparatus according to claim 3, characterised in that the guide means are formed by a deflector plate (132).

5. Apparatus according to one of claims 1 to 4, characterised in that a colour film guiding device (35) is provided which is movable between at least two positions (36, 44) and which changes the path of the colour film at least in the region of the opening.

6. Apparatus according to claim 5, characterised in that the colour film guiding device (35) has a rod (36) extending at right angles to the direction of movement of the colour film, this rod being mounted at both ends in a wheel (37, 38), each wheel being rotatably mounted in the housing, the axes of the two wheels (37, 38) lying on a straight line, and an actuating device (40) is provided which turns the two wheels (37, 38) synchronously.

7. Apparatus according to claim 6, characterised in that the actuating device (40) has an actuating spindle passing through it, mounted in the housing (2), on which two sprockets (39) which mesh with external teeth on the wheels (37, 38) are secured for rotation with said spindle.

8. Apparatus according to claim 7, characterised in that a guide roller (43) is rotatably mounted on the actuating spindle.

9. Apparatus according to claim 7 or 8, characterised in that the actuating spindle passes through the housing at both ends and at one end a handle (41) and at the other end a gear lever (42) are connected for rotation with said actuating spindle.

10. Apparatus according to one of claims 1 to 9, characterised in that the supply roller (11) and the waste roller (10) each have an associated roller braking device (19), which brakes the roller in question when there are no external forces acting upon it.

11. Apparatus according to one of claims 1 to 10, characterised in that the housing (2) has two side walls (4, 5) connected to one another in which the supply roller (11) and the waste roller (10) are rotatably mounted and at least one of which has a recess (48) proceeding from the edge between the supply roller and waste roller.

12. Apparatus according to claim 11, characterised in that the height of the side walls (4, 5) is greater than the maximum roller diameter and the height of the recess (48) corresponds at least to the maximum roller diameter.

13. Apparatus according to claim 11 or 12, characterised in that the side walls (4, 5) for the supply roller (11) and for the waste roller (10) each have a bearing slot (6, 7, 8, 9) proceeding from the edge, in which a roller journal (13, 14) is mounted.

14. Apparatus according to claim 13, characterised in that the supply roller and/or the waste roller have a core (12) which is hollow at least at the ends, in which the journals (13, 14) are inserted.

15. Apparatus according to one of claims 1 to 14, characterised in that at least the waste roller (10) is drivable.

16. Apparatus according to one of claims 1 to 15, characterised in that the supply roller (11) and/or the waste roller (10) each have a cover (33, 25) which at least partly envelops the associated roller.

17. Apparatus according to claim 16, characterised in that the cover (33) is hinged to the housing (2) and can be folded back.

18. Apparatus according to one of claims 1 to 17, characterised in that the peeling edge (30) is incorporated in the cover (25) associated with the waste roller (10).

19. Apparatus according to one of claims 1 to 18, characterised in that a sensor (50) is provided which detects the diameter of the supply roller (11).

20. Apparatus according to one of claims 1 to 19, characterised in that a movable covering (35) is provided which protects the colour-bearing film (31) in the region of the opening (48) and is pushed into the housing (2) when the colour film supplying apparatus is placed in a laminator, thereby freeing the opening (48).

## Revendications

1. Dispositif de préparation de films de couleur comprenant un rouleau d'alimentation pour recevoir un film de couleur non utilisé, dans lequel le rouleau d'alimentation (11) est monté, conjointement avec un rouleau de déchet (10) pour recevoir le film de couleur utilisé (31), dans un boîtier transportable (2) en forme de cassette, une section du film de couleur (31) s'étendant entre le rouleau d'alimentation (11) et le rouleau de déchet (10) et le boîtier (2) présentant une ouverture entre le rouleau d'alimentation et le rouleau de déchet, qui est au moins aussi large que le film de couleur et offre un accès libre aux deux côtés du film de couleur, caractérisé en ce que, dans la partie du boîtier (2) affectée au rouleau de déchet (10) se trouve une arête de séparation (30), qui agit sur le film de couleur et produit un pli dans le trajet de déplacement du film de couleur.

2. Dispositif selon la revendication 1, caractérisé en ce que le pli présente un angle supérieur ou égal à 70°.

3. Dispositif selon la revendication 1 ou 2, caractérisé en ce qu'un dispositif de changement de direction (32, 132) est affecté à l'arête de séparation (30).

4. Dispositif selon la revendication 3, caractérisé en ce que le dispositif de changement de direction est formé par une tôle déflectrice (132).

5. Dispositif selon l'une quelconque des revendications 1 à 4, caractérisé en ce qu'il est prévu un dispositif de guidage de films de couleur (35), qui peut être déplacé entre au moins deux positions (36, 44) et modifie le trajet du film de couleur au moins dans la zone de l'ouverture.

6. Dispositif selon la revendication 5, caractérisé en ce que le dispositif de guidage de films de couleur (35) présente une tige (36) s'étendant transversalement à la direction de déplacement du film de couleur, qui est montée sur les deux côtés respectivement sur une roue (37, 38), qui est montée respectivement à rotation dans le boîtier, les arbres des deux roues (37, 38) se trouvant sur une ligne droite et un dispositif de commande (40) étant prévu pour faire tourner en synchronisme les deux roues (37, 38).

7. Dispositif selon la revendication 6, caractérisé en ce que le dispositif de commande (40) présente un arbre de commande continu monté dans le boîtier (2), sur lequel deux roues dentées (39) sont montées sans pouvoir tourner et s'engrènent par une denture extérieure sur les roues (37, 38).

8. Dispositif selon la revendication 7, caractérisé en ce qu'un rouleau de changement de direction (43) est monté à rotation sur l'arbre de commande.

9. Dispositif selon la revendication 7 ou 8, caractérisé en ce que l'arbre de commande traverse le boîtier sur les deux côtés et, à une extrémité, une manette (41) et, à l'autre extrémité, un levier de commutation (42) sont reliés à l'arbre de commande sans pouvoir tourner.

10. Dispositif selon l'une quelconque des revendications 1 à 9, caractérisé en ce que, pour le rouleau d'alimentation (11) et le rouleau de déchet (10), il est prévu respectivement un dispositif de freinage de rouleau (19), qui freine le rouleau respectif lorsqu'aucune force n'agit sur lui de l'extérieur.

11. Dispositif selon l'une quelconque des revendications 1 à 10, caractérisé en ce que le boîtier (2) présente deux parois latérales (4, 5) reliées l'une à l'autre, dans lesquelles le rouleau d'alimentation (11) et le rouleau de déchet (10) sont montés à rotation et dont au moins l'une présente un évidement (48) partant du bord entre le rouleau d'alimentation et le rouleau de déchet.

12. Dispositif selon la revendication 11, caractérisé en ce que les parois latérales (4, 5) présentent une hauteur plus importante que celle du diamètre de rouleau le plus grand et la hauteur de l'évidement (48) correspond au moins au diamètre du rouleau le plus grand.

13. Dispositif selon la revendication 11 ou 12, caractérisé en ce que les parois latérales (4, 5) pour le rouleau d'alimentation (11) et pour le rouleau de déchet (10) présentent respectivement une fente de montage (6, 7, 8, 9) partant du bord et dans laquelle, respectivement, un tourillon de palier à rouleaux (13, 14) est monté.

14. Dispositif selon la revendication 13, caractérisé en ce que le rouleau d'alimentation et/ou le rouleau de déchet présente une âme (12) creuse au moins aux extrémités, dans laquelle les tourillons (13, 14) sont insérés.

15. Dispositif selon l'une quelconque des revendications 1 à 14, caractérisé en ce qu'au moins le rouleau de déchet (10) peut être entraîné.

16. Dispositif selon l'une quelconque des revendications 1 à 15, caractérisé en ce que, pour le rouleau d'alimentation (11) et/ou le rouleau de déchet (10), il est prévu respectivement un couvercle (33, 25) qui entoure au moins partiellement le rouleau concerné.

17. Dispositif selon la revendication 16, caractérisé en ce que le couvercle (33) est articulé et peut être rabattu sur le boîtier (2).

18. Dispositif selon l'une quelconque des revendications 1 à 17, caractérisé en ce que l'arête de séparation (30) est intégrée au couvercle (25) affecté au rouleau de déchet (10).

19. Dispositif selon l'une quelconque des revendications 1 à 18, caractérisé en ce qu'il est prévu un capteur (50) qui détecte le diamètre du rouleau d'alimentation (11).

20. Dispositif selon l'une quelconque des revendications 1 à 19, caractérisé en ce qu'il est prévu un couvercle mobile (35), qui protège le film de couleur (31) dans la zone de l'ouverture (48) et qui, lors de l'insertion du dispositif de préparation de films de couleur dans un dispositif à laminer, est déplacé dans le boîtier (2) en libérant l'ouverture (48).
